# EUROPÄISCHE PATENTSCHRIFT

(11) **EP 0 660 263 B1**
(45) Veröffentlichungstag und Bekanntmachung des Hinweises auf die Patenterteilung: **01.03.2000**
(21) Anmeldenummer: 94119110.8
(22) Anmeldetag: 05.12.1994
(51) Int. Cl.: G06M 1/27, G06M 1/272, G01D 5/34, G01D 5/24, G01F 15/06, G01R 11/16

(54) **Verfahren zum elektrischen Auslesen eines mehrstelligen Rollenzählwerks für ein Volumenmessgerät**
Method for providing electrical signal readout of a multi-digit drum-counter for use in a flow-meter
Procédé pour lire les position des roues d'un compteur à rouleaux à plusieurs chiffres pour un compteur de débit

(30) Priorität: 23.12.1993 CH 385493
(43) Veröffentlichungstag der Anmeldung: 28.06.1995
(73) Patentinhaber: GWF Gas- & Wassermesserfabrik AG, CH-6002 Luzern (CH)
(72) Erfinder: Mettler, Roland, Dipl. Phys., CH-6010 Kriens (CH); Vischer, Dieter, Dipl. El. Ing., CH-6300 Zug (CH)
(74) Vertreter: Blöchle, Hans

(56) Entgegenhaltungen:
- EP-A- 0 119 545
- CH-A- 614 776
- GB-A- 2 130 828
- US-A- 4 031 386

## Beschreibung

Es sind Volumenmessgeräte für Gas und Wasser wie auch Elektrizitätszähler zur Messung der durchgeströmten Energie bekannt, in welchen das gemessene Volumen respektive die gemessene Energie mit einer dem Messgerät angepassten Untersetzung auf ein mechanisches Rollenzählwerk übertragen wird. Das Rollenzählwerk zeigt dabei die seit der letzten Nullstellung respektive die seit der Inbetriebnahme durchgeflossene Menge an. Zur Bestimmung des Verbrauchs während einer bestimmten Periode wird der Stand des Rollenzählwerkes zu Beginn und am Ende dieser Periode abgelesen. Eine bevorzugte Ausführung für das Rollenzählwerk besteht aus einer Achse, auf welcher die Zahlenrollen drehbar angebracht sind und auf deren Umfang die Ziffern 0 bis 9 aufgebracht sind, sowie aus einer zweiten Achse mit darauf drehbaren Schaltritzeln derart, dass jeweils die kleinerwertige Zahlenrolle im letzten Zehntel einer Umdrehung über das zugeordnete Schaltritzel die nächst höherwertige Rolle um eine Zehntelumdrehung weiterschaltet. Ein Rollenzählwerk für ein Messgerät für Wasser findet sich zum Beispiel in der DE 2 244 404 A1. Je nach Ausführung des Messgerätes ist es zur Erzielung eines grossen Messbereichs mit einer guten Messgenauigkeit wichtig, das zum Antrieb des Rollenzählwerkes erforderliche Drehmoment möglichst klein zu halten.

Aus US 3 732 404 ist eine Lösung zur elektronischen Auslesung eines Zählwerkes bekannt, in welcher die kontinuierliche Drehbewegung der Zahlenrollen in eine schnappende Bewegung übersetzt wird. Dabei ist sicherzustellen, dass die für die schnappende Bewegung verwendete Feder o.ä. genügend Energie aufnimmt, um das ganze Rollenzählwerk eine Stellung vorwärts zu drehen, beispielsweise von 19999 auf 20000. Aus der EP 202722 B1 ist eine Lösung bekannt, welche die elektronische Auslesung für ein Zählwerk vom Nadeltyp unter der Verwendung von mechanischen Kontakten ohne Schnappbewegung erlaubt. Allen obigen Lösungen ist gemeinsam, dass mit ihnen eine Erhöhung des zum Antrieb des Rollenzählwerkes erforderlichen Drehmomentes verbunden ist.

Aus US-A-4,031,386 ist die optoelektronische Auslesung von Rollenzählwerken bekannt, wobei die Sensoren senkrecht zur Zahlenrollenachse angeordnet sind.

Die senkrechte Anordnung von einen Gray-Code liefernden Sensoren zu einer sich drehenden Achse ist optoelektronisch für eine Wettermeßeinrichtung aus GB-A-2,130,828 und kapazitiv für Maschinenelemente aus CH-A-614,776 bekannt.

Der vorliegenden Erfindung liegt die Aufgabe zu Grunde, den Anzeigestand eines Rollenzählwerkes in einem Messgerät mit möglichst einfachen Mitteln zu einem beliebigen Zeitpunkt digital elektronisch auszulesen, ohne dass durch die dazu notwendigen Mittel das zum Antrieb des Rollenzählwerkes erforderliche Drehmoment wesentlich verändert wird.

Diese Aufgabe wird durch das Rollenzählwerk gemäß Patentanspruch 1 gelost.

Gemäss vorliegender Erfindung wird der Anzeigestand eines mechanischen Rollenzählwerkes mittels geeigneter, fest angeordneter berührungsloser Sensoren elektronisch ausgelesen, ohne dass einschränkende Bedingungen an die Drehbewegung des Rollenzählwerkes wie zum Beispiel eine schnappende Drehung erfüllt sein müssen. Um die Anzeige eines nicht schnappenden Rollenzählwerkes in allen Stellungen und unter Berücksichtigung des mechanisch notwendigen Spiels des Rollengetriebes mit statischen Sensoren zuverlässig auszulesen, ist es erforderlich, dass die Sensoren pro Umdrehung der Rolle mindestens 22 verschiedene Signalzustände annehmen. Damit ist es möglich, den Drehwinkel jeder Zahlenrolle mit einer Unsicherheit von weniger als 18° zu messen und die relative Stellung zweier benachbarter Rollen mit einer Unsicherheit von weniger als 36° festzustellen und somit den Anzeigestand des Rollenzählwerkes zuverlässig zu ermitteln. In einer Vorzugslösung nehmen die Sensoren pro Umdrehung 30 unterschiedliche Signalzustände an, symmetrisch verteilt mit einem Drehwinkel der Zahlenrolle von 12° pro Signalzustand. Bei dieser Lösung ist ein mechanisches Spiel von Zahlenrolle zu Zahlenrolle von bis zu knapp 12° zulässig, unabhängig von der Anzahl der auszulesenden Zahlenrollen.

Eine aus Anwendungen zur Detektion einer mechanischen Position mit mehreren Sensoren allgemein bekannte Anforderung an die Signalzustände ist, dass in der Art eines Gray-Codes von Zustand zu Zustand jeweils nur ein Signal ändert.

Mehrere Ausführungsbeispiele der Erfindung sind in der Zeichnung dargestellt und in der nachfolgenden Beschreibung näher erläutert. Ein erstes Ausführungsbeispiel ist in Figur 1a teilgeschnitten gemäss Linie 1a - 1a in Figur 1b und in Figur 1b im Querschnitt gemäss Linie 1b - 1b in Figur 1a gezeigt. Figur 2a zeigt ein zweites und Figur 2b ein drittes Ausführungsbeispiel. Figur 3 zeigt alle möglichen Codes zum dritten Ausführungsbeispiel. Ein viertes Ausführungsbeispiel ist in Figur 4a in Ansicht und in Figur 4b im Querschnitt gezeigt. Figur 5a zeigt ein fünftes Ausführungsbeispiel und ein sechstes Ausführungsbeispiel ist in Figur 5b in Teilansicht und in Figur 5c im Querschnitt gezeigt.

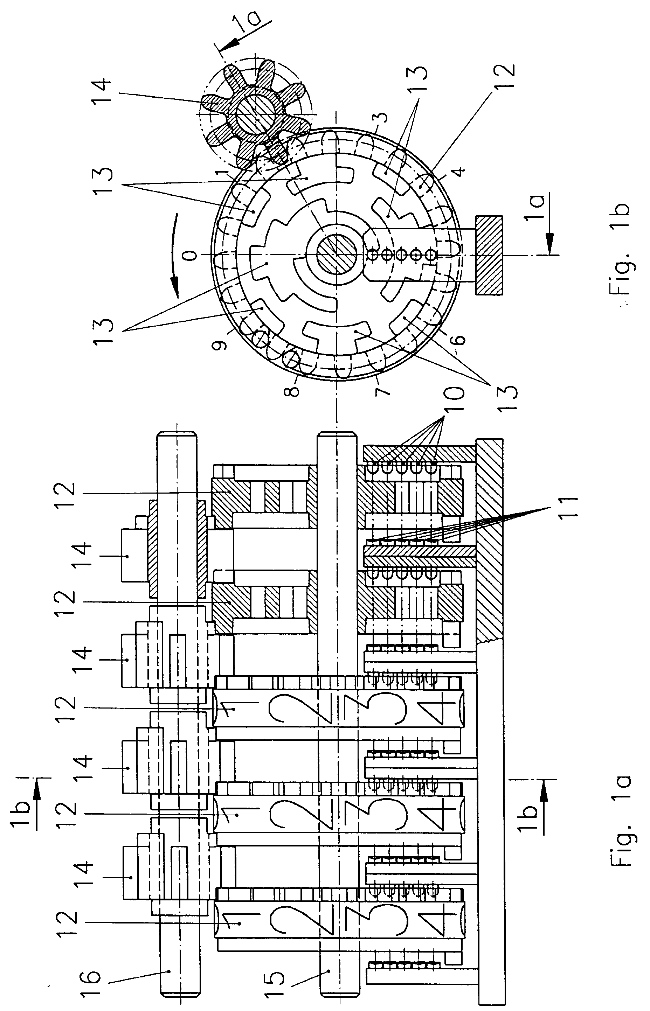

Das erste Ausführungsbeispiel arbeitet mit Einweglichtschranken, die optische Sensoren aufweisen. Auf einer Zahlenrollenachse 15 sind mehrere Zahlenrollen 12 angeordnet, die über Schaltritzel 14 mechanisch miteinander in Verbindung stehen. Die Schaltritzel 14 sitzen auf einer Schaltritzelachse 16. Die Zahlenrollen 12 sind durch eine nicht dargestellte Blende in herkömmlicher Weise visuell ablesbar. Zum elektronischen Auslesen sind seitlich der Zahlenrollen 12 einerseits fünf Lichtquellen 10 und andererseits fünf Sensoren oder Lichtempfänger 11 mit jeweils unterschiedlichem Radialabstand angeordnet. An jeder Zahlenrolle 12 befindet sich ein geeigneter mehrspuriger binärer Code 13 (siehe Fig. 1b), der aus lichtdurchlässigen und lichtundurchlässigen Segmenten besteht (siehe Figur 1a). Diese Lösung stellt wegen des zwangsläufig geringen Abstand der einzelnen Codespuren hohe Anforderungen an die Genauigkeit der Sensoren und des Codes auf den Zahlenrollen.

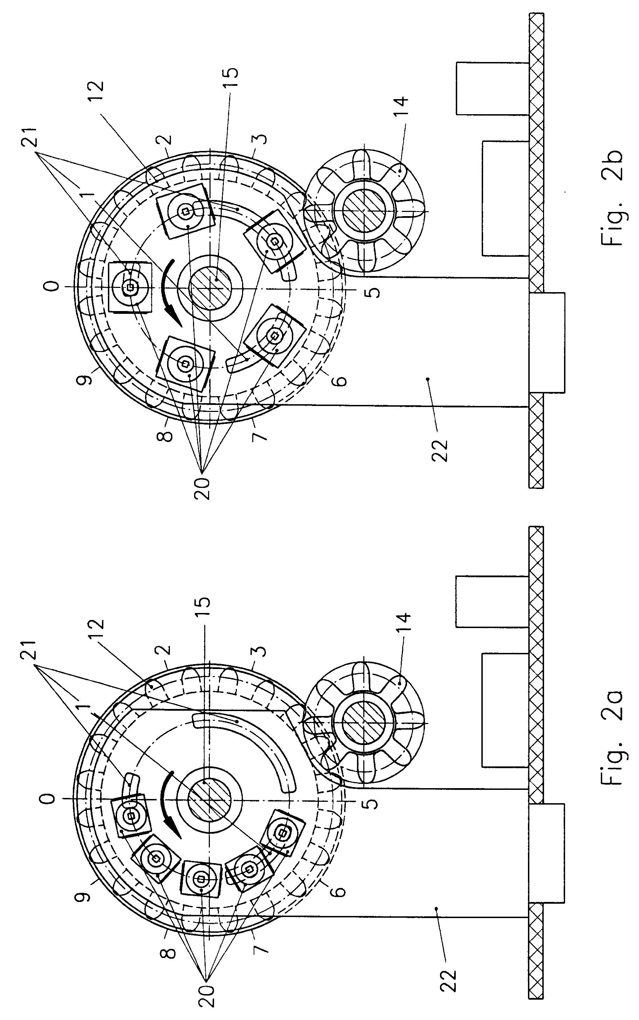

Gemäss des zweiten Ausführungsbeispiels werden ebenfalls fünf Sensoren 20 pro Zahlenrolle 12 verwendet, die wie im ersten Ausführungsbeispiel Teile von Einweglichtschranken sind. Die Sensoren 20 sind auf einem Sensorprint 22 alle mit gleichem Radialabstand auf einem Kreisbogen um die Zahlenrollenachse 15 und in einer radialen Ebene angebracht. Für eine rationelle Montage ist es vorteilhaft, alle fünf Sensoren 20 möglichst nahe beieinander in einer Hälfte des Umfangs der Zahlenrollen 12 anzubringen. Dies ist in einer Anordnung mit Winkeln von je 36° zwischen den fünf Sensoren 20 gegeben. (Figur 2 a).

Für eine möglichst zuverlässige Ausführung des Encoders ist es vorteilhaft, in den 30 verwendeten Signalzuständen die Zustände "1 1 1 1 1" (alle Sensoren ein) und "0 0 0 0 0" (alle Sensoren aus) nicht zu berücksichtigen, so dass ein globaler Test der Sensorfunktion möglich ist. Dazu sind die fünf Sensoren 20 über den ganzen Umfang gleichmässig verteilt mit Winkeln von 72° anzuordnen (Figur 2 b). Andere mögliche Ausführungen haben die Sensoren 20 mit Winkeln von 72°, 36°, 36°, 72° oder 36°, 72°, 36°, 108° angeordnet.

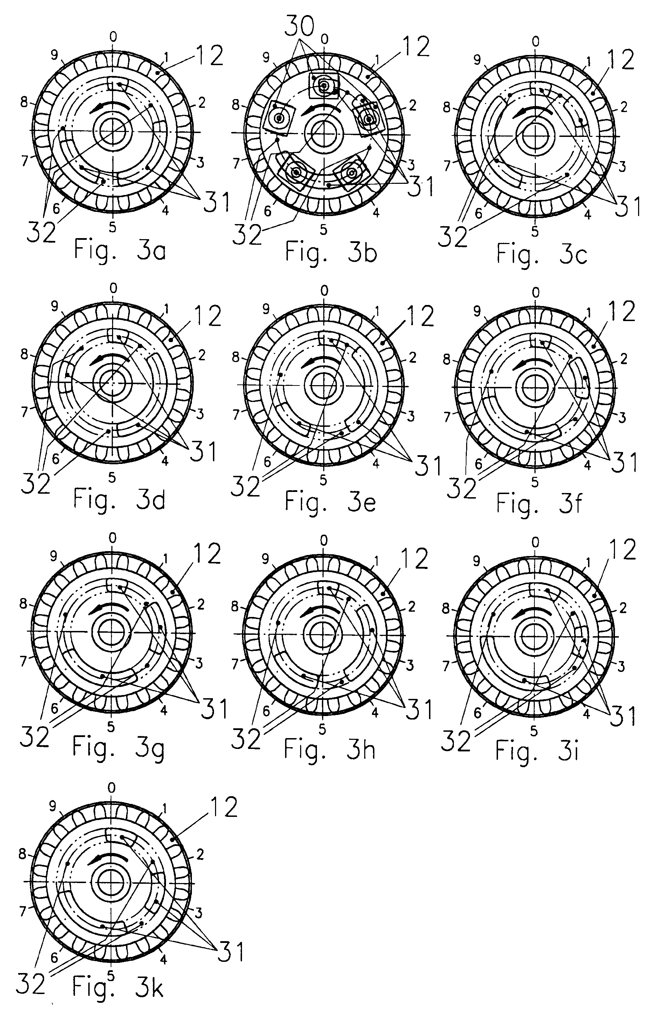

Die möglichen Codes 21 auf den Zahlenrollen 12 sind in den Figuren 3a, 3b, 3c, 3d, 3e, 3f, 3g, 3h, 3i und 3k dargestellt. Sie bestehen aus drei Segmenten einer ersten Art 31 und aus drei Segmenten einer zweiten Art 32. Die sechs Trennlinien zwischen den Segmenten 31, 32 der Codes 21 sind in folgenden Winkeln auf den Zahlenrollen 12 angeordnet:
Variante a: 18°, 78°, 174°, 198°, 258°, 354°
Variante b: 18°, 42°, 78°, 126°, 246°, 354°
Variante c: 18°, 42°, 78°, 198°, 318°, 354°
Variante d: 18°, 54°, 174°, 258°, 294°, 354°
Variante e: 18°, 42°, 150°, 198°, 246°, 354°
Variante f: 18°, 54°, 102°, 150°, 258°, 354°
Variante g: 18°, 54°, 114°, 150°, 246°, 354°
Variante h: 18°, 54°, 150°, 186°, 246°, 354°
Variante i: 30°, 78°, 114°, 162°, 270°, 354°
Variante k: 30°, 78°, 126°, 162°, 258°, 354°

Die Varianten b bis k sind nur für radialsymmetrisch verteilte Sensoren 30, das heisst eine Verteilung mit gleichen Winkeln zwischen den Sensoren, verwendbar (siehe Fig. 2b). Die Codes 21 können auch gedreht oder gespiegelt werden. In Figur 3b sind beispielhaft auch die fünf Sensoren 30 gezeigt. Bei Einweglichtschranken werden die Segmente der ersten Art durch Löcher gebildet, die Segmente der zweiten Art bestehen aus Stegen. Es wäre auch die Verwendung von Reflexlichtschranken möglich, wobei dann die Segmente der ersten Art sich durch ihre Relexionseigenschaften von denen der zweiten Art deutlich unterscheiden müssten.

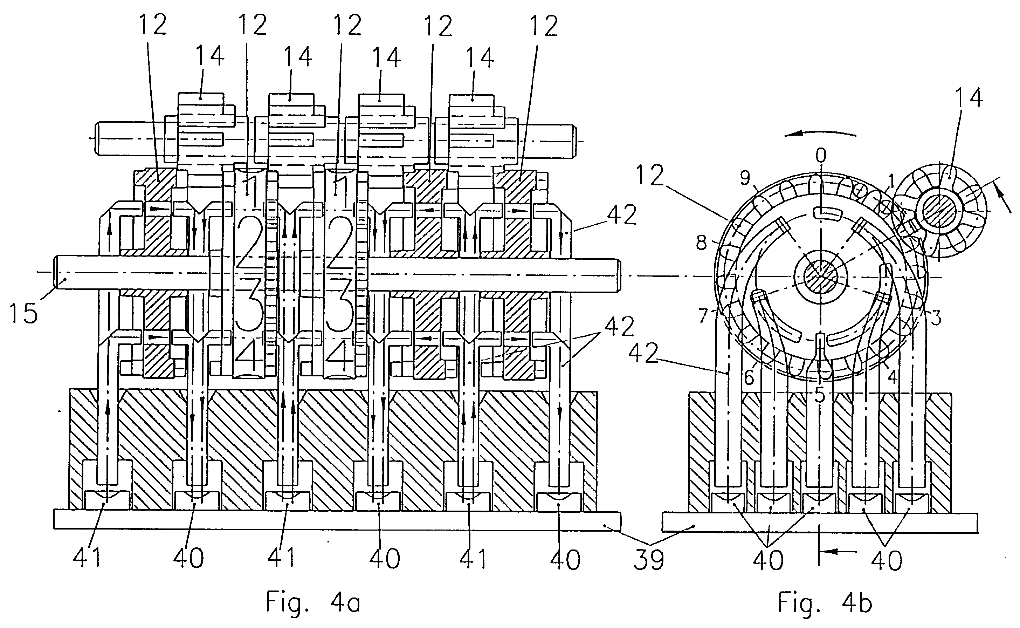

Eine für die Herstellung grösserer Stückzahlen vorteilhafte Gestaltung von optischen Sensoren besteht aus auf einem Print 39 parallel zur Achse 15 der Zahlenrollen 12 angeordneten fotoelektrischen Elementen 40, 41. Die Elemente 41 wirken als Lichtquellen, deren Licht durch formgepresste Lichtleiter 42 auf den codetragenden Teil der Zahlenrolle 12 gelenkt wird (Figur 4). Die Elemente 40 sind optische Sensoren, z.B. Photowiderstände. Die Pfeile auf den Lichtleitern geben jeweils die Strahlrichtung des Lichts an.

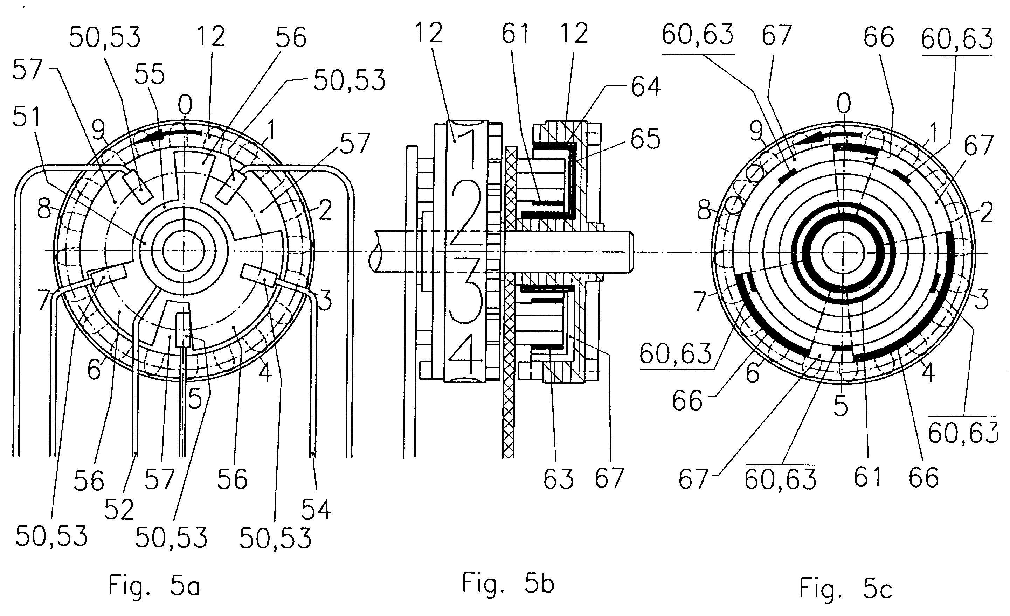

Eine andere kostengünstige Sensorvariante gemäss einem fünften Ausführungsbeispiel ist mit kapazitiven Sensoren 50 ausgestattet (Figur 5a). Parallel zur Zahlenrolle 12 ist achsnah ein elektrisch leitender Innenring 51 mit Anschluss 52 angebracht. Die gegenüber den Zahlenrollen 12 feststehenden Sensoren bestehen aus fünf schmalen, unter gleichen Winkelabständen angeordneten Fühlerplättchen 53 mit elektrischen Anschlüssen 54. Innenring 51 und Fühlerplättchen 53 sind in einer Radialebene, vorzugsweise auf einer isolierenden Platte und mit geringem Radialabstand zur Zahlenrolle 12 angeordnet. Die Zahlenrolle 12 trägt eine Codescheibe 55 mit je drei leitenden 56 und drei nicht leitenden Segmenten 57. Zur Bestimmung der Stellung einer Zahlenrolle wird die Kapazität zwischen dem Innenring 51 und den einzelnen Fühlerplättchen 53 an den Anschlüssen 52 und 54 gemessen.

Die Figuren 5b und 5c zeigen in einem sechsten Ausführungsbeispiel ebenfalls eine kapazitive Variante mit Sensor 60 in Radialanordnung. Die Kapazitäten jeweils zwischen einem metallischen Innenzylinder 61 und fünf radial davon beabstandeten schmalen Fühlerplättchen 63 gemessen. Die Zahlenrolle 12 weist seitlich in einer Ringnut 64 einen Codezylinder 65 mit abwechselnd metallischen und nichtmetallischen Segmenten (66, 67) auf. In diesem Fall liegt der Codezylinder 65 nicht zwischen Fühlerplättchen 63 und Innenring bzw. -zylinder 61, aber nahe genug bei den Fühlerplättchen 63, dass die gemessene Kapazität ausreichend beeinflusst wird.

Anstatt der kapazitiven Sensoren können ebensogut auch entsprechend ausgebildete induktive Sensoren verwandt werden.

## Patentansprüche

1. Mehrstelliges Rollenzählwerk für ein Volumenmessgerät für Gas oder Wasser oder für einen Elektrizitätszähler, in welchem von jeweils zwei Zahlenrollen die höherwertige Zahlenrolle von der niederwertigen im letzten Zehntel deren Umdrehung über ein Schaltritzel um eine Zehntelumdrehung weitergedreht wird, und wobei pro auszulesende Zahlenrolle (12) berührungslose Sensoren (11, 20, 30, 50, 60) auf einem Durchmesser in einer Ebene senkrecht zur Zahlenrollenachse (15) angebracht sind, **dadurch gekennzeichnet** dass auf die Zahlenrollen (12) drei Segmente (31, 56, 66) einer ersten Art mit lichtdurchlässiger oder nichtreflektierender Eigenschaft und drei Segmente (32, 57, 67) einer zweiten Art mit lichtsperrender oder reflektierender Eigenschaft einen, durch Ablesung mittels fünf Sensoren (11, 20, 30, 50, 60), binären Code (13, 21, 55, 65) erzeugend angebracht sind, derart, dass bei einer vollen Umdrehung einer Zahlenrolle (12) mit mindestens einer Variante der Teilungswinkel der Segmenttrennlinien die fünf Sensoren (11, 20, 30, 50, 60) bis zu zweiunddreissig verschiedene Signalzustände erzeugen, wobei die fünf Sensoren (11, 20, 30, 50, 60) als auf einem Print (39) parallel zur Achse (15) der Zahlenrollen (12) angeordnete fotoelektrische Elemente (40, 41) und formgepresste Lichtleiter (42) ausgeführt sind.

2. Mehrstelliges Rollenzahlwerk nach Anspruch 1, **dadurch gekennzeichnet**, dass eine der folgenden Varianten a-k für die Teilungswinkel der Segmenttrennlinien vorhanden ist:
Variante a: 18°, 78°, 174°, 198°, 258°, 354°
Variante b: 18°, 42°, 78°, 126°, 246°, 354°
Variante c: 18°, 42°, 78°, 198°, 318°, 354°
Variante d: 18°, 54°, 174°, 258°, 294°, 354°
Variante e: 18°, 42°, 150°, 198°, 246°, 354°
Variante f: 18°, 54°, 102°, 150°, 258°, 354°
Variante g: 18°, 54°, 114°, 150°, 246°, 354°
Variante h: 18°, 54°, 150°, 186°, 246°, 354°
Variante i: 30°, 78°, 114°, 162°, 270°, 354°
Variante k: 30°, 78°, 126°, 162°, 258°, 354°.

3. Mehrstelliges Rollenanzeigewerk nach Anspruch 1 oder 2, dadurch gekennzeichnet, dass der Code (13, 21) aus ungleich langen Segmenten (31, 32; 56, 57, 66, 67) besteht, die auf einem Kreisbogen angeordnet sind.

4. Mehrstelliges Rollenanzeigewerk nach einem der Ansprüche 1 bis 3 dadurch gekennzeichnet, dass die Sensoren (11, 20, 30, 50, 60) alle auf einem Kreisbogen im gleichen Radialabstand von der Zahlenrollenachse (15) angeordnet sind.

5. Mehrstelliges Rollenanzeigewerk nach einem der Ansprüche 1 bis 4 dadurch gekennzeichnet, dass die Sensoren (11, 20, 30) als optische Sensoren, insbesondere Fotodetektoren ausgebildet sind, die Teil einer Einweglichtschranke sind.

6. Mehrstelliges Rollenanzeigewerk nach einem der Ansprüche 1 bis 4, dadurch gekennzeichnet, dass die Sensoren (50, 60) als kapazitive Sensoren ausgebildet sind.

7. Mehrstelliges Rollenanzeigewerk nach Anspruch 6, dadurch gekennzeichnet, dass die fünf kapazitiven Sensoren (50, 60) als schmale metallisierte Fühlerplättchen (53, 63) ausgebildet sind und sich in der unmittelbaren Nähe der Fühlerplättchen (53, 63) eine Codescheibe (55) oder ein Codezylinder (65) befindet, welche oder welcher abwechselnd metallische (56, 66) und nichtmetallische Segmente (57, 67) aufweist und dass die Kapazität zwischen den Fühlerplättchen (53, 63) und einem elektrisch leitenden Innenring (51, 61) gemessen wird.

## Claims

1. Multidigit counting wheel mechanism for a volume-measuring instrument for gas or water or for an electricity meter, in which of each two counting wheels the higher digit counting wheel is turned further through one tenth of a revolution by way of a "carry" pinion by the lower digit one in the last tenth of its revolution, and wherein contactless sensors (11, 20, 30, 50, 60) for each counting wheel (12) to be read out are mounted on a diameter in a plane perpendicular to the counting wheel axle (15), characterised in that three segments (31, 56, 66) of a first kind with a light-permeable or non-reflective characteristic and three segments (32, 57, 67) of a second kind with a light-blocking or reflective characteristic, which segments produce a binary code (13, 21, 55, 65) through reading by means of five sensors (11, 20, 30, 50, 60), are mounted on the counting wheels (12) in such a manner that the five sensors (11, 20, 30, 50, 60) generate up to thirty-two different signal states in one complete revolution of a counting wheel (12) with at least one variant of the pitch angle of the segment dividing lines, wherein the five sensors (11, 20, 30, 50, 60) are executed as photoelectric elements (40, 41) and mould-pressed optical conductors (42) arranged on a print (39) parallel to the axis (15) of the counting wheels (12).

2. Multidigit wheel display mechanism according to claim 1 or 2, characterised in that one of the following variants a-k is present for the pitch angle of the segment dividing lines:
Variant a: 18°, 78°, 174°, 198°, 258°, 354°
Variant b: 18°, 42°, 78°, 126°, 246°, 354°
Variant c: 18°, 42°, 78°, 198°, 318°, 354°
Variant d: 18°, 54°, 174°, 258°, 294°, 354°
Variant e: 18°, 42°, 150°, 198°, 246°, 354°
Variant f: 18°, 54°, 102°, 150°, 258°, 354°
Variant g: 18°, 54°, 114°, 150°, 246°, 354°
Variant h: 18°, 54°, 150°, 186°, 246°, 354°
Variant i: 30°, 78°, 114°, 162°, 270°, 354°
Variant k: 30°, 78°, 126°, 162°, 258°, 354°

3. Multidigit wheel display mechanism according to claim 1 or 2, characterised in that the code consists of unequally long segments (31, 32; 56, 57, 67), which are arranged on a circular arc.

4. Multidigit wheel display mechanism according to one of claims 1 to 3, characterised in that the sensors (11, 20, 30, 50, 60) are all arranged on a circular arc at equal radial spacing from the counting wheel axle (15).

5. Multidigit wheel display mechanism according to one of claims 1 to 4, characterised in that the sensors (11, 20, 30) are constructed as optical sensors, in particular as photodetectors, which are part of a one-way light barrier.

6. Multidigit wheel display mechanism according to one of claims 1 to 4, characterised in that the sensors (50, 60) are constructed as capacitive sensors.

7. Multidigit wheel display mechanism according to claim 6, characterised in that the five capacitive sensors (50, 60) are constructed as narrow metallised sensor platelets (53, 63) and a code disc (55) or a code cylinder (65), either of which has metallic segments (56, 66) and non-metallic segments (57, 67) in alternation, is disposed in the immediate proximity of the sensor platelets (53, 63) and that the capacitance is measured between the sensor platelets (53, 63) and an electrically conductive inner ring (51, 61).

## Revendications

1. Mécanisme compteur à roues à chiffres à plusieurs chiffres, pour un appareil de mesure du volume pour eau ou gaz ou pour un compteur d'électricité, dans lequel, chaque fois parmi deux roues à chiffres, la roue à chiffres de la position plus élevée est tournée d'un dixième de tour par celle d'une position plus basse, dans le dernier dixième de son tour, par l'intermédiaire d'un pignon de commande, et dans lequel, pour chaque roue à chiffres (12) à lire, des capteurs sans contact physique (11, 20, 30, 50, 60) sont disposés sur un diamètre, dans un plan perpendiculaire à l'axe (15) des roues à chiffres, caractérisé en ce que, sur les roues à chiffres (12), sont disposés trois segments (31, 56, 66) d'un premier genre, possédant une propriété de transparence ou de non réfléchissement et trois segments (32, 57, 67) d'un deuxième genre, ayant une propriété d'arrêt de la lumière ou de réfléchissement, qui produisent un code binaire (13, 21, 55, 65) par lecture au moyen de cinq capteurs (11, 20, 30, 50, 60), de telle manière qu'à un tour complet d'une roue à chiffres (12) qui possède au moins une variante de l'angle de division des lignes de séparation des segments, les cinq capteurs (11, 20, 30, 50, 60) produisent jusqu'à trente-deux états de signal différents, les cinq capteurs (11, 20, 30, 50, 60) étant constitués par des éléments photoélectriques (40, 41) disposés sur un circuit imprimé (39) parallèlement à l'axe (15) des roues à chiffres (12), et des conducteurs de lumière (42) moulés par compression.

2. Mécanisme compteur à roues à chiffres à plusieurs chiffres selon la revendication 1, caractérisé en ce qu'est présente une des variantes suivantes a-k pour les angles de division des lignes de séparation des segments :
variante a : 18°, 78°, 174°, 198°, 258°, 354°
variante b : 18°, 42°, 78°, 126°, 246°, 354°
variante c : 18°, 42°, 78°, 198°, 318°, 354°
variante d : 18°, 54°, 174°, 258°, 294°, 354°
variante e : 18°, 42°, 150°, 198°, 246°, 354°
variante f : 18°, 54°, 102°, 150°, 258°, 354°
variante g : 18°, 54°, 114°, 150°, 246°, 354°
variante h : 18°, 54°, 150°, 186°, 246°, 354°
variante i : 30°, 78°, 114°, 162°, 270°, 354°
variante k : 30°, 78°, 126°, 162°, 258°, 354°

3. Mécanisme compteur à roues à chiffres à plusieurs chiffres selon la revendication 1 ou 2, caractérisé en ce que le code (13, 21) est composé de segments (31, 32 ; 56, 57, 66, 67) de longueurs inégales qui sont disposés sur un arc de cercle.

4. Mécanisme compteur à roues à chiffres à plusieurs chiffres selon une des revendications 1 à 3, caractérisé en ce que les capteurs (11, 20, 30, 50, 60) sont tous disposés sur un arc de cercle à la même distance radiale de l'axe (15) des roues à chiffres.

5. Mécanisme compteur à roues à chiffres à plusieurs chiffres selon l'une des revendications 1 à 4, caractérisé en ce que les capteurs (11, 20, 30) sont constitués par des capteurs optiques, en particulier par des photodétecteurs, qui font partie d'un barrage photoélectrique à une voie.

6. Mécanisme compteur à roues à chiffres à plusieurs chiffres selon l'une des revendications 1 à 4, caractérisé en ce que les capteurs (50, 60) sont constitués par des capteurs capacitifs.

7. Mécanisme compteur à roues à chiffres à plusieurs chiffres selon la revendication 6, caractérisé en ce que les cinq capteurs capacitifs (50, 60) sont constitués par d'étroites plaquettes palpeuses métallisées (53, 63) et qu'à proximité immédiate des plaquettes palpeuses (53, 63) se trouve un disque de code (55) ou un cylindre de code (65), qui présente des segments alternativement métalliques (56, 66) et non métalliques (57, 67) et en ce que la capacité est mesurée entre les plaquettes palpeuses (53, 63) et une bague intérieure (51, 61) conductrice de l'électricité.
